# EUROPÄISCHE PATENTSCHRIFT

(11) **EP 2 388 602 B1**
(45) Veröffentlichungstag und Bekanntmachung des Hinweises auf die Patenterteilung: **25.07.2018**
(21) Anmeldenummer: 10163130.7
(22) Anmeldetag: 18.05.2010
(51) Int. Cl.: H02S 50/10, G01R 31/02, G01R 31/04, G01R 31/28

(54) **Verfahren zur Diagnose von Kontakten einer Photovoltaikanlage und Vorrichtung**
Method for diagnosing contacts of a photovoltaic assembly and device
Procédé destiné au diagnostic de contacts d'une installation photovoltaïque et dispositif

(43) Veröffentlichungstag der Anmeldung: 23.11.2011
(73) Patentinhaber: SMA Solar Technology AG, 34266 Niestetal (DE)
(72) Erfinder: Hopf, Markus, 34314 Espenau (DE); Bettenwort, Gerd, 34119 Kassel (DE); Bieniek, Sebastian, 35066 Frankenberg (DE)

(56) Entgegenhaltungen:
- EP-A1- 1 918 727
- DE-A1- 3 509 201
- JP-A- 2009 032 743
- US-A1- 2007 257 681

## Beschreibung

Die Erfindung betrifft ein Verfahren zur Diagnose, insbesondere Überwachung, von Kontakten einer Photovoltaikanlage.

Eine Photovoltaikanlage stellt mittels Photovoltaik elektrische Energie zur Verfügung.

Insbesondere betrifft die Erfindung ein Verfahren zur Überwachung von Kontakten einer ein oder mehrere Photovoltaikmodule aufweisenden Photovoltaikanlage zur Erkennung des Auftretens von den bestimmungsgemäßen Betrieb der Photovoltaikanlage beeinträchtigenden Ereignissen.

Im Betrieb der Photovoltaikanlagen können hohe elektrische Ströme auftreten, welche u. U. im Zusammenwirken mit defekten und/oder schadhaften Komponenten der Photovoltaikanlage zu erheblichen Leistungsverlusten führen können. Dies betrifft insbesondere Kontaktwiderstände von Kontakten von Verbindungsstellen von Modulen untereinander wie auch elektrische Leitungsanschlüsse. Kontaktfehler machen sich u. a. durch eine Erhöhung des Übergangswiderstandes der betreffenden elektrischen Verbindung bemerkbar.

DE 10 2006 052 295 B3 beschreibt ein Verfahren und eine Schaltungsanordnung zur Überwachung eines Photovoltaikgenerators, wobei ein Grundprinzip zur Generatordiagnose mit Signaleinkopplung und Messung zwischen einem PV-Generator (= Photovoltaikgenerator) und einem Wechselrichter angegeben wird. Detaillierte Angaben werden nicht gemacht. Das Verfahren beschränkt sich außerdem auf die Nachtstunden ohne Einstrahlung, in denen der Wechselrichter keine Netzeinspeisung vornimmt und somit kein Stromfluss in den Gleichstromleitungen des PV-Generators vorhanden ist.

Bislang sind kein zufriedenstellendes Verfahren und keine zufriedenstellende Vorrichtung bekannt, um Kontakte einer Photovoltaikanlage zu überwachen.

Die Erfindung zielt vor diesem Hintergrund darauf ab, dieses Problem zu lösen.

Die Erfindung erreicht dieses Ziel mit einem Verfahren entsprechend dem Anspruch 1 und einer Vorrichtung nach Anspruch 12.

Dabei wird vorzugsweise mittels eines in die Photovoltaikanlage eingekoppelten Testsignals mit unterschiedlichen Frequenzen eine Generatorimpedanz der Photovoltaikanlage unabhängig von Betriebszuständen der Photovoltaikanlage ermittelt und es werden durch Modellieren eines Wechselstromverhaltens der Photovoltaikanlage anhand eines Betrags und einer Phaseninformation der ermittelten Generatorimpedanz Rückschlüsse auf die Kontakte gezogen.

Dazu wird ein Verfahren vorgeschlagen, welches besonders bevorzugt folgende Verfahrensschritte aufweist:
- Einkoppeln eines mehrere Frequenzen umfassenden Testsignals in die Photovoltaikanlage,
- Auskoppeln eines dem Testsignal zugeordneten Antwortsignals aus der Photovoltaikanlage und Ermitteln einer Generatorimpedanz der Photovoltaikanlage mittels einer Auswertung des Antwortsignals; und
- Überwachen von Kontakten der Photovoltaikanlage - insbesondere unabhängig von Betriebszuständen der Photovoltaikanlage - durch Modellieren eines Wechselstromverhaltens der Photovoltaikanlage anhand eines Betrags und einer Phaseninformation der ermittelten Generatorimpedanz.

Damit ist es möglich, dass die Photovoltaikanlage sozusagen rund um die Uhr überwacht werden kann, unabhängig von ihren Betriebszuständen. Dabei können die Betriebszustände unter anderem umfassen: Einstrahlung am Tag, geringe Einstrahlung (z.B. in der Dämmerung), keine Einstrahlung in den Nachtstunden, geringe und erhebliche Verschattung, Volllast-, Teillast- und Leerlaufzustände, ein- und ausgeschalteter Zustand u.dgl.

Der besondere Vorteil dabei besteht darin, dass Fehler erkennbar sind, sobald sie auftreten und nicht erst in der Nacht, wenn keine Einstrahlung mehr erfolgt.

Die notwendige Phaseninformation der ermittelten Generatorimpedanz kann anhand eines Realteils der Generatorimpedanz und eines Imaginärteils der Generatorimpedanz ermittelt werden.

Das Wechselstromverhalten der Photovoltaikanlage wird anhand eines Ersatzschaltbilds (ESB) modelliert. Das analytisch entworfene ESB gibt dabei eine Schaltung an, die das Wechselstromverhalten annähernd bzw. fast identisch beschreibt. Aus dem ESB ergibt sich ein funktionaler Zusammenhang der frequenzabhängigen Generatorimpedanz, mit dessen Hilfe sich durch Modellierung der Kenngrößen der einzelnen Komponenten des ESB (Widerstands-, Induktivitäts- und Kapazitätswerte) das Wechselstromverhaltens des ESB bestmöglich auf das ermittelte Wechselstromverhalten des Photovoltaikgenerators angepasst werden kann. Anhand der so bestimmten Kenngrößen (oder einer Untermenge dieser Kenngrößen) kann die Photovoltaikanlage überwacht werden, zum Beispiel in Bezug auf die Höhe eines Kontaktwiderstandes. Durch geschickte Wahl des ESB kann hierbei erreicht werden, dass zumindest eine der Kenngrößen des ESB einen Wert aufweist, der im Wesentlichen unabhängig von Betriebszuständen der Photovoltaikanlage ist. Bei Nutzung einer solchen Kenngröße kann die Überwachung zuverlässig und unabhängig vom Betriebszustand der Photovoltaikanlage durchgeführt werden.

Ist die Zuleitung sehr lang, so kann dies für hohe Frequenzen durch eine Erweiterung des zugrunde gelegten ESB um eine weitere Zuleitungsinduktivität, einen weiteren Zuleitungswiderstand, sowie gegebenenfalls einer Zuleitungskapazität, welche zwischen den Zuleitungen angeordnet ist, nachgebildet werden.

Hierbei sei explizit erwähnt, dass die Werte der Zuleitungsinduktivität, des Zuleitungswiderstandes und der Zuleitungskapazität nicht notwendigerweise ausschließlich der Zuleitung selbst zugeordnet werden, sondern dass auch der Generator, insbesondere die elektrischen Verbindungen innerhalb des Generators einen Beitrag zu deren Wert leisten können.

Eine weitere Verbesserung der Nachbildung des Wechselstromverhaltens des Photovoltaikgenerators durch ein Ersatzschaltbild kann dadurch erfolgen, dass das Ersatzschaltbild eine Kombination mehrerer Teilersatzschaltbilder umfasst, wobei jedes Teilersatzschaltbild einen Teil der Photovoltaikanlage nachbildet.

So kann ein erstes Teilersatzschaltbild einen sich in einem einheitlichen ersten Betriebszustand befindenden Teil der Photovoltaikanlage und ein zweites Teilersatzschaltbild einen sich in einem einheitlichen zweiten Betriebszustand befindenden zweiten Teil der Photovoltaikanlage nachbilden.

Ein Temperatureinfluss kann zum Beispiel dadurch berücksichtigt werden, dass zumindest ein Teilersatzschaltbild eine entsprechende temperaturabhängige Komponente umfasst. Die Temperatur kann beispielsweise durch eine Messung ergänzend bestimmt werden. Alternativ kann auch aus dem Wechselstromverhalten, bzw. den sich aus der Modellierung desselben ergebenden Kenngrößen auf die Temperatur geschlossen werden.

Eine Auswertung beim Überwachen von Kontakten der Photovoltaikanlage kann außerdem auf der Basis von Expertenwissen durchgeführt werden, wobei eine große Anzahl von bereits bekannten Ereignissen und deren Eigenschaften zur schnellen Erkennung von Fehlerzuständen beitragen kann. Das Expertenwissen kann beispielsweise in der Form eines Regelwerkes vorliegen, wobei die Regeln zum Beispiel in einer Datenverarbeitungsanlage bzw. dessen Programmcode abgelegt sein können.

Eine Vorrichtung zur Überwachung von Kontakten einer Photovoltaikanlage weist Folgendes auf: einen Funktionsgenerator zur Erzeugung eines Testsignals mit einer festlegbaren Anzahl von Teilsignalen mit unterschiedlichen Frequenzen; eine Einkopplungseinrichtung zur Einkopplung des Testsignals in die Photovoltaikanlage; eine Mess- und Auswertungseinrichtung zur Messung und Auswertung einer Messspannung und eines Messstroms, und zur Ermittlung einer Generatorimpedanz der Photovoltaikanlage; eine Bearbeitungseinrichtung zur Bestimmung bzw. Identifikation von Parametern; und vorzugsweise eine Weiterverarbeitungs- und Speichereinrichtung zur Überwachung von Kontakten der Photovoltaikanlage unabhängig von Betriebszuständen der Photovoltaikanlage durch Modellierung eines Wechselstromverhaltens der Photovoltaikanlage und Vergleichen mit vorher festgelegten Referenzwerten oder vorher identifizierten Referenzwerten.

Die Weiterverarbeitungs- und Speichereinrichtung kann eine Auswerteeinrichtung zur Charakterisierung mindestens einer Eigenschaft, die zum Beispiel einer Alterung von Komponenten und/oder Degradation von Kontakten der Photovoltaikanlage zugeordnet werden kann, aufweisen.

In einer Ausführung ist die Vorrichtung in einen Wechselrichter der Photovoltaikanlage integriert, wodurch sich ein kompakter Aufbau mit einfacher Installation und zuverlässigem Betrieb ergibt.

Das Wechselstromverhalten der Photovoltaikanlage kann somit durch eine Ersatzschaltung, die ein Ersatzschaltbild festlegt, angenähert beschrieben werden.

Dabei ist eine Berechnung bzw. eine Modellierung dieses Verhaltens durch Bestimmung der zugehörigen Kenngrößen des ESB erforderlich. Die Kenngrößen werden aus einem Testsignal ermittelt, das zuvor in die Photovoltaikanlage eingekoppelt wurde. Dabei umfasst dieses Testsignal mehrere Frequenzen, wodurch ein Frequenzgang der Photovoltaikanlage und deren Generatorimpedanz erfassbar sind. Aus dem Betrag, dem Realteil und dem Imaginärteil dieser Generatorimpedanz lassen sich die für die Modellierung erforderlichen Informationen, unter anderem auch eine notwendige Phaseninformation, bestimmen.

Derart ist es auf einfache Weise möglich, sämtliche zur Modellierung erforderlichen Parameter zu erhalten. Dabei kann die Photovoltaikanlage im Einspeisebetrieb in ein Netz oder von diesem entkoppelt sein, unter Teillast oder Volllast betrieben werden, Einstrahlung oder Verschattung aufweisen.

Die Überwachung ist insbesondere auch unabhängig vom Betriebszustand der Photovoltaikanlage möglich. Randbedingungen der Photovoltaikanlage, zum Beispiel unterschiedliche Zellenbauarten, Betriebszustände, Leitungslängen u.dgl., lassen sich in einfacher Weise mittels kombinierter Teilersatzschaltbilder zu Ersatzschaltbildern zusammensetzen, um so das Wechselstromverhalten der Photovoltaikanlage nachzubilden. Mit dieser Kenntnis ist es möglich, das aktuelle Verhalten mit bekannten Werten zu vergleichen, den Betriebszustand der Anlage zu diagnostizieren, und somit Fehler sofort beim Auftreten zu erkennen.

Es ist nach einer vorteilhaften Variante des Verfahrens auch möglich, über längere Zeiträume Aufzeichnungen der ermittelten Impedanzwerte oder Kenngrößen anzufertigen bzw. abzuspeichern und auszuwerten, um so zum Beispiel aufgrund eines Langzeitverhaltens Degradationen und Verschleiß bzw. Alterung feststellen zu können.

In einer vorteilhaften Ausgestaltung der Erfindung kann die Vorrichtung inklusive eines Signalgenerators und einer Steuereinrichtung in das Gehäuse des Wechselrichters integriert sein, aber eine Anordnung dieser Komponenten ganz oder teilweise außerhalb des Gehäuses des Wechselrichters ist ebenfalls denkbar.

Nachfolgend wird die Erfindung unter Bezugnahme auf die beiliegenden Zeichnungen näher beschrieben. Es zeigen:
- Fig. 1: ein beispielhaftes Blockschaltbild einer elektrischen Anlage mit einer Photovoltaikanlage zur Erläuterung einer Generatorimpedanzbestimmung;
- Fig. 2: eine beispielhafte Diagrammdarstellung eines gemessenen und modellierten Betrags einer Generatorimpedanz in Abhängigkeit einer Frequenz;
- Fig. 3: ein beispielhaftes erstes Ersatzschaltbild;
- Fig. 4: ein beispielhaftes zweites Ersatzschaltbild;
- Fig. 5: eine beispielhafte Darstellung zur Verschaltung von Zellen/Modulen unterschiedlicher Betriebszustände mit zugehörigen Ersatzschaltbildern;
- Fig. 6: ein beispielhaftes drittes Ersatzschaltbild;
- Fig. 7a-d: beispielhafte Diagrammdarstellungen von Messwerten und modellierten Werten einer Generatorimpedanz in Abhängigkeit einer Frequenz bei verschiedenen Betriebszuständen; und
- Fig. 8: ein beispielhaftes Blockschaltbild einer elektrischen Anlage mit einer Photovoltaikanlage mit einem Ausführungsbeispiel einer erfindungsgemäßen Vorrichtung.

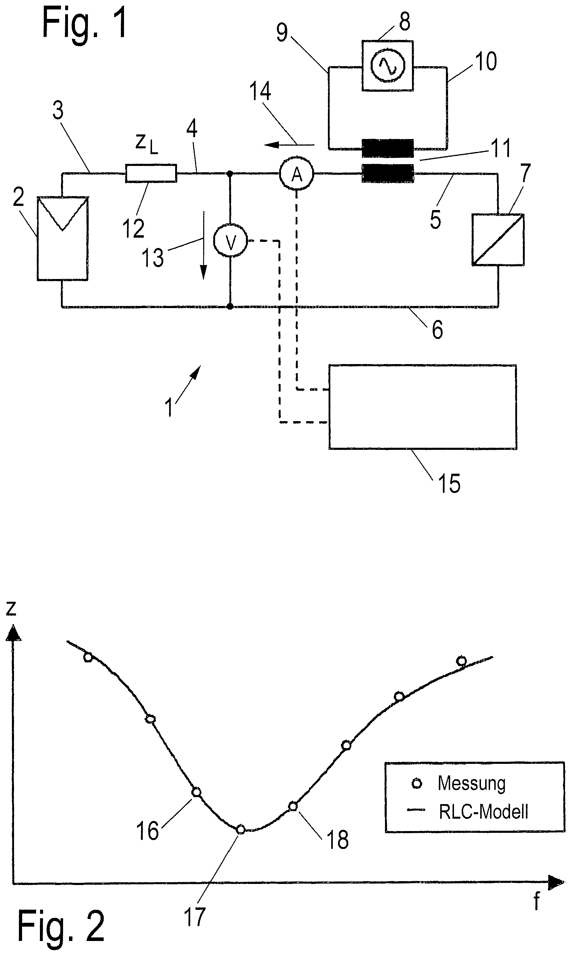

Fig. 1 zeigt ein beispielhaftes Blockschaltbild einer übergeordneten elektrischen Anlage, die eine Photovoltaikanlage 1 aufweist, umfassend wenigstens ein Photovoltaikmodul 2, zur Erläuterung einer Generatorimpedanzbestimmung.

Das Photovoltaikmodul ist über elektrische Leitungen 3, 4, 5, 6 mit einem Wechselrichter 7 verbunden. Der im Folgenden verwendete Begriff PV-Generator bezeichnet die gesamten photovoltaischen Elemente der Photovoltaikanlage 1, die Strahlung in elektrische Energie umwandeln, sowie deren Zuleitung. In der vorliegenden Fig. 1 weist der PV-Generator hierzu das Photovoltaikmodul 2 auf. Weiterhin dargestellt ist ein zur Erzeugung eines Testsignals ausgestalteter Funktionsgenerator 8, der über elektrische Leitungen 9, 10 mit einer zur Einkopplung des Testsignals in den Gleichstromkreis der Photovoltaikanlage 1 ausgestalteten Einkopplungseinrichtung 11, beispielsweise einem Übertrager, verbunden ist. Gezeigt ist weiterhin eine Impedanz Z_{L} 12, welche die Zuleitungsimpedanz des PV-Generators 2 abbildet.

Zur Überwachung des Gleichstromkreises der Photovoltaikanlage 1 wird ein eine Anzahl von Teilsignalen unterschiedlicher Frequenz aufweisendes Testsignal durch den Funktionsgenerator 8 erzeugt und über die Einkopplungseinrichtung 11 in den Gleichstromkreis eingespeist. Im Rahmen eines Messzyklus wird die Frequenz der Teilsignale beispielsweise im Bereich von etwa 10...1000 kHz schrittweise oder kontinuierlich erhöht, so dass sich ein Testsignal mit einer Anzahl - beispielsweise sinusförmiger - Schwingungsanregungen ergibt, deren Frequenz abgestuft zu- oder abnimmt. Ausgehend von einer Schwingungsanregung mit einer minimalen Frequenz wird für jeden Frequenzschritt der Momentanwert einer am PV-Generator anliegenden Messspannung 13 und ein im Gleichstromkreis fließender Messstrom 14 (hierbei sind die Messspannung 13 und der Messstrom 14 jeweils dem Testsignal zugeordnete Komponenten eines Antwortsignals der Photovoltaikanlage 1) mittels einer Mess- und Auswertungseinrichtung 15 gemessen und gespeichert. Weiterhin wird außerdem die Frequenz des Testsignals für jeden Spannungs- und Strommesspunkt erfasst und gespeichert. Selbstverständlich ist der überstrichene Frequenzbereich an die Gegebenheiten der zu überwachenden Photovoltaikanlage 1 angepasst. Die Mess- und Auswertungseinrichtung 15 berechnet bzw. modelliert aus den gespeicherten Spannungs- und Stromwerten für jede ebenfalls gespeicherte Frequenz des Testsignals eine komplexwertige Generatorimpedanz Z_{PV}. Die Bestimmung der komplexwertigen Generatorimpedanz Z_{PV} erfolgt hierbei durch Methoden aus dem Stand der Technik. Man erhält so einen zu der jeweiligen Einkoppelfrequenz f zugehörigen Betrag der Generatorimpedanz Z_{PV}. Fig. 2 zeigt dazu eine beispielhafte Diagrammdarstellung eines gemessenen und modellierten Betrags der Generatorimpedanz Z_{PV}. Hierbei stellen die Kreise gemessene Werte und die durchgezogene Linie den modellierten Verlauf des Betrages der Generatorimpedanz |Z| dar.

Zur Berechnung des ohmschen Widerstandes R (der einen Kennwert zur Überwachung des Gleichstromkreises bildet) der Generatorimpedanz Z_{PV} wird ein Ersatzschaltbild (ESB) in Form eines Reihenschwingkreises (eine Reihenschaltung aus einem ohmschen Widerstand R, einer Spule L und einer Generatorkapazität C) verwendet. Aus drei gemessenen Werten für den Betrag der Generatorimpedanz |Z| 16, 17, 18 und den dazugehörigen Frequenzwerten lassen sich nun die Werte für R, L und C des gewählten ESB bestimmen. Die hierzu erforderlichen Randbedingungen und die Berechnungsvorschriften sind dem Fachmann bekannt und werden daher nicht näher erläutert.

Die Photovoltaikanlage 1 wird durchgehend, ggf. in bestimmten zeitlichen Abständen, mit dem beschriebenen Testsignal beaufschlagt. Dabei wird der Verlauf der mittels der beschriebenen Vorgehensweise bestimmten Größe R beobachtet. Erhöht sich R über einen bestimmten Grenzwert, so wird auf das Auftreten eines zu hohen Kontaktwiderstandes geschlossen.

Angemerkt sei noch, dass die kreisförmigen Datenpunkte in Fig. 2 aus Messungen an einer Photovoltaikanlage 1 stammen, während die Werte der durchgezogenen Linie aus einer Berechnung mit einem ESB stammen, dessen Daten für R, L und C wie oben beschrieben ermittelt wurden.

Außerdem wird der in Fig. 2 dargestellte Verlauf des Betrags der Generatorimpedanz IZI nur in Dämmerungs- und Nachtstunden, d.h. ohne Einstrahlung in die Photovoltaikanlage 1, erhalten.

Somit muss ein einer Auswertung zu Grunde liegendes Ersatzschaltbild der Photovoltaikanlage 1 an eine Anzahl bauartbedingter Faktoren und/oder eine Anzahl betriebartbedingter Faktoren angepasst werden.

Unter bauartbedingten Faktoren der Photovoltaikanlage 1 wird u. a. im Folgenden verstanden: eine Zuleitungslänge, ein Modultyp eines Photovoltaikmoduls 2, ein Zellentyp eines Photovoltaikmoduls 2, eine Zellenzahl eines Photovoltaikmoduls 2, eine Verschaltungsart, eine Photovoltaikmodulanzahl eines Strings oder eine Stringanzahl eines PV-Generators.

Unter betriebsartbedingten Faktoren wird u. a. im Folgenden eine Einstrahlung auf einen PV-Generator oder auf einen Teil eines PV-Generators, eine Temperatur eines PV-Generators oder eine Temperatur eines Teils eines PV-Generators oder ein Arbeitspunkt eines PV-Generators oder eines Teils eines PV-Generators verstanden.

Es sei daraufhin gewiesen, dass Ersatzschaltbilder (ESB) im vorliegenden Kontext dazu dienen, das Wechselstromverhalten (also das Verhalten bei Anregung mit einem Wechselstromtestsignal) eines PV-Generators oder eines Teils eines PV- Generators nachzubilden. Aus den erfassten Messwerten werden dann mittels geeigneter Berechnungs- und Auswerteverfahren ein oder mehrere Kennwerte aus dem gewählten ESB ermittelt, wobei unter einem Kennwert eines ESB ein Wert eines Bauteils, beispielsweise eines Widerstandes R, verstanden wird. Der oder die ermittelten Kennwerte werden dann zum Erkennen des Auftretens eines Ereignisses verwendet, welches den bestimmungsgemäßen Betrieb einer Photovoltaikanlage 1 beeinträchtigt. Demzufolge kann der funktionale Zusammenhang der frequenzabhängigen Impedanz entsprechend des ESB mathematisch exakt abgebildet werden, wodurch alle Kenngrößen des ESB (Widerstände, Induktivitäten, Kapazitäten) bestimmbar sind. Alternativ kann aber auch eine für den in der Messung verwendeten Frequenzbereich ausreichend genaue Näherungsformel verwendet werden, mittels derer gegebenenfalls nur einen Teil der Kenngrößen des ESB explizit bestimmbar sind, zum Beispiel nur die für eine Überwachung des PV-Generators relevanten Kenngrößen wie ein Widerstandswert. Auf diese Weise kann der rechnerische Aufwand bei der Bestimmung der Kenngrößen deutlich reduziert werden.

Im Folgenden werden verschiedene Ausführungen zur Anpassung eines ESB erläutert.

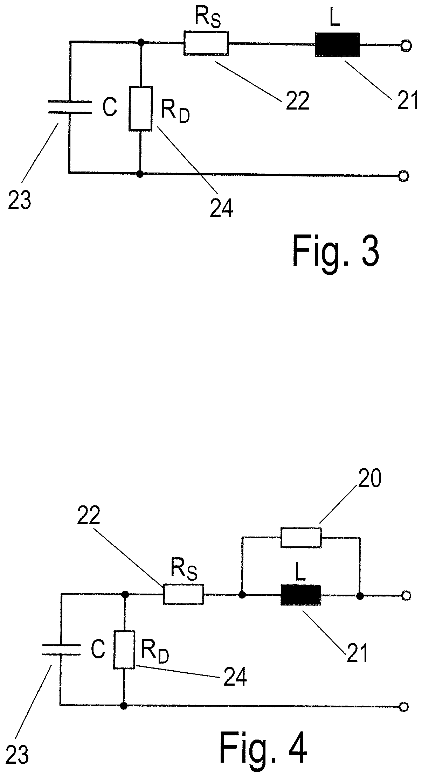

Fig. 3 zeigt ein erstes ESB zur Nachbildung des elektrischen Wechselstromverhaltens eines PV-Generators oder eines Teils eines PV-Generators (Zelle, Photovoltaikmodul 2), falls sich alle Teile des PV-Generators in einem nahezu gleichen Betriebszustand befinden. D. h. alle Teile des betrachteten PV-Generators sind beispielsweise der gleichen Temperatur und/oder der gleichen Einstrahlung ausgesetzt. In diesem Fall umfasst das ESB eine Generatorkapazität C 23, der ein Generatorwiderstand R_{D} 24 parallel geschaltet ist. Diesen Elementen ist weiterhin ein Serienwiderstand R_{S} 22 und eine Zuleitungsinduktivität L 21 nachgeschaltet. Optional kann, wie in Fig. 4 gezeigt, der Zuleitungsinduktivität L 21 noch ein weiterer Zuleitungswiderstand 20 parallel geschaltet sein.

In den beiden ESB gemäß Fig. 3 und Fig. 4 bildet die Parallelschaltung aus Zuleitungsinduktivität L 21 und Zuleitungswiderstand 20 das induktive Verhalten einer (langen) Zuleitung, und der elektrischen Verbindungen innerhalb der PV-Module nach. Der Serienwiderstand Rₛ 22 bildet den ohmschen Serienanteil der PV-Module und deren Zuleitungen nach, und beinhaltet einen Anteil, der den Kontaktwiderständen der diversen elektrischen Kontaktpunkte innerhalb der PV-Module und zu dessen Zuleitungen zugeordnet ist. Die Parallelschaltung aus C 23 und R_{D} 24 kann hauptsächlich dem Verhalten der PV-Module zugeordnet werden.

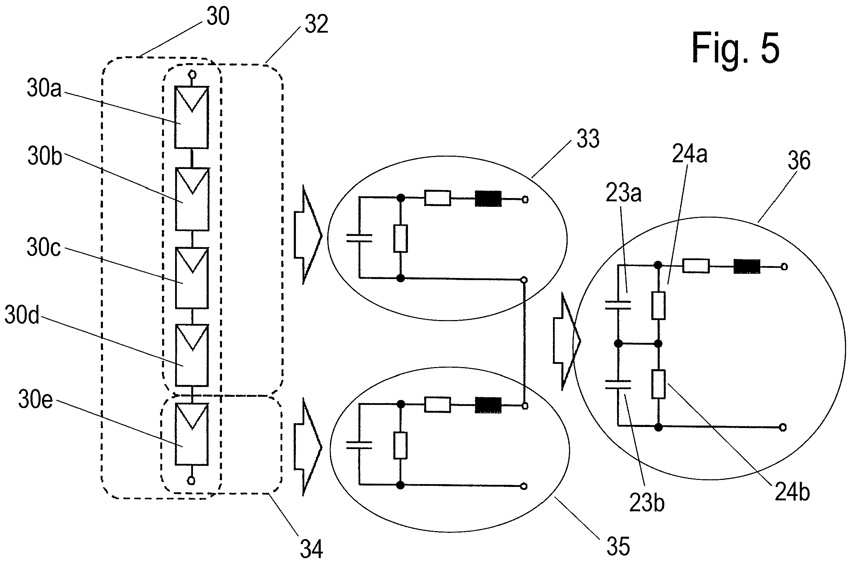

Fig. 5 ist eine beispielhafte Darstellung zur Verschaltung von Zellen/Modulen unterschiedlicher Betriebszustände mit zugehörigen Ersatzschaltbildern und zeigt einen Photovoltaikgenerator 30 (PV-Generator) in Form einer Reihenschaltung aus fünf Zellen 30a bis 30e. Es handelt sich bei den Zellen 30a bis 30e um Zellen gleicher Bauart. Mit anderen Worten weisen die Zellen 30a bis 30e gleiche bauartbedingte Faktoren auf. Die Zellen 30a bis 30d befinden sich in einem gleichen Betriebszustand (beispielsweise unterliegen diese Zellen einer gleichen Einstrahlung oder weisen die gleiche Temperatur auf), anders ausgedrückt weisen die Zellen 30a bis 30d gleiche betriebsartbedingte Faktoren auf, und bilden eine erste Zellengruppe 32. Zelle 30e befindet sich in einem anderen Betriebszustand (beispielsweise eine andere Einstrahlung oder eine andere Temperatur aufweisend) und bildet eine zweite Zellengruppe 34.

Untersuchungen im Rahmen der vorliegenden Erfindung haben ergeben, dass die erste Zellengruppe durch ein erstes Teilersatzschaltbild (TESB) 33 und die zweite Zellengruppe durch ein zweites TESB 35 in ihrem Wechselstromverhalten nachgebildet werden können, wobei die TESB in Reihe geschaltet sind und jeweils einem der in Fig. 3 bzw. Fig. 4 beschriebenen ESB entsprechen. Beide TESB 33, 35 können hierbei zu einem zusammengefassten ESB 36 kombiniert werden, welches jeweils nur einen Serienwiderstand und nur eine Zuleitungsinduktivität enthält. Die Anzahl der Paare von parallel geschalteten Generatorkapazitäten 23a, 23b und Generatorwiderständen 24a, 24b entsprechen hierbei weiterhin der Anzahl von Zellengruppen, die im zusammengefassten ESB 36 enthalten sind.

Weiterhin kann in dem Fall, dass die erste und zweite Zellengruppe einen identischen Betriebszustand aufweisen, das zusammengefasste ESB 36 weiter vereinfacht werden in ein ESB gemäß Fig. 3 bzw. Fig. 4.

Hierbei ist offensichtlich, dass bei einer Zusammenfassung von zwei oder mehr TESB zu einem zusammengefassten ESB eine Anpassung der Werte der einzelnen Bauteile der einzelnen TESB erfolgen muss.

Gleichzeitig ist es in einer Anwendung des erfindungsgemäßen Verfahrens möglich, aufgrund der Entscheidung, ob zwei oder mehr TESB, ein zusammengefasstes ESB, oder ein ESB gemäß Fig. 3 bzw. Fig. 4 zur ausreichend genauen Beschreibung des Wechselstromverhaltens der Photovoltaikanlage 1 führen, den Zustand der Photovoltaikanlage 1 zu diagnostizieren. So kann beispielsweise das Vorliegen und der Umfang einer Verschattung der Zellen des Photovoltaikgenerators 30 auf diese Weise erkannt werden.

Es sei an dieser Stelle angemerkt, dass die Aufteilung der Zellen in Zellengruppen nicht nur durch die Betriebsbedingungen verursacht sein kann, sondern sich auch bauartbedingt ergeben kann. Wird zum Beispiel ein PV-Modul eines Photovoltaikgenerators 30 durch ein sich von den anderen Modulen unterscheidendes, neues PV-Modul ersetzt, kann sich auch die Notwendigkeit einer Aufteilung des Photovoltaikgenerators 30 in Zellengruppen mit zugeordneten TESB ergeben, um eine möglichst genaue Abbildung des Wechselstromverhaltens zu erreichen. In diesem Fall ist regelmäßig eine Zusammenfassung der TESB selbst bei identischen Betriebsbedingungen nicht möglich.

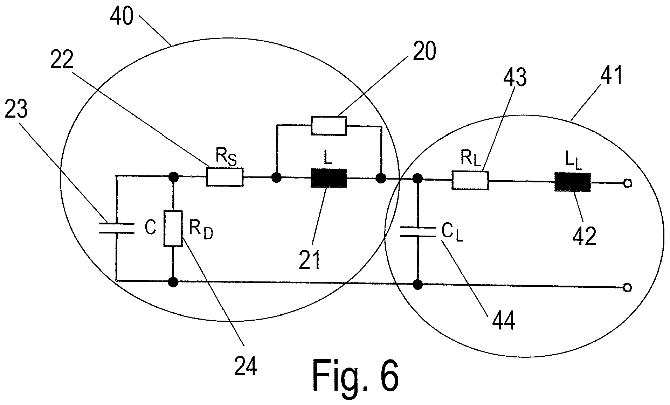

Fig. 6 zeigt ein drittes Ersatzschaltbild als eine weitere Anpassung eines ESB (vgl. Fig. 3 bzw. 4) an einen bauartbedingten Faktor. Überschreitet eine Zuleitungslänge einer Zuleitung (nicht dargestellt) einen bestimmten Wert und/oder werden hohe Frequenzen (z.B. größer als 350 kHz) betrachtet, so kann die Auswirkung der Zuleitung gegebenenfalls nicht mehr vernachlässigt werden und muss im ESB des PV-Generators durch ein weiteres TESB 41 für das Verhalten der Zuleitung ergänzt werden. Hierbei stellt L_{L} eine weitere Zuleitungsinduktivität 42, R_{L} einen weiteren Zuleitungswiderstand 43 und C_{L} eine weitere Zuleitungskapazität 44 dar.

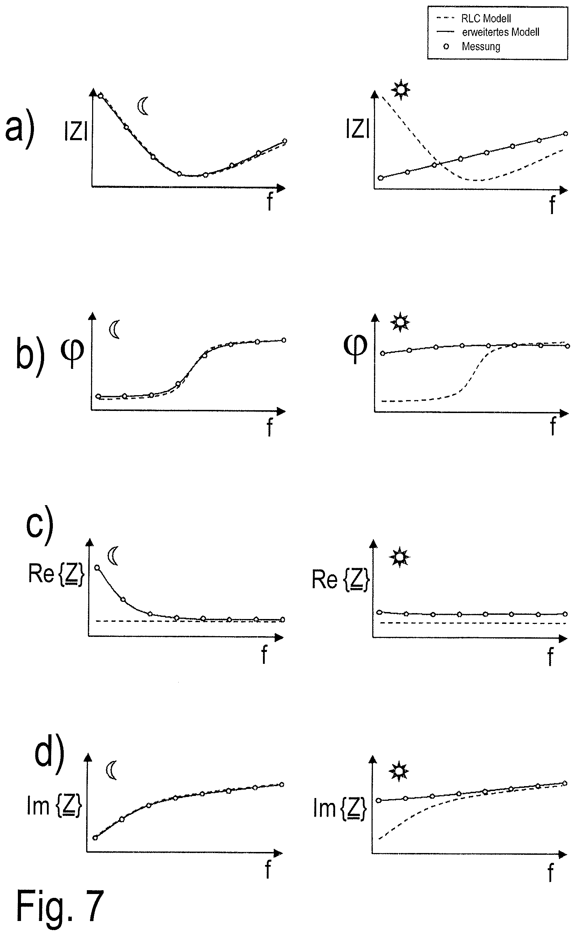

Die Auswirkung der Anpassung eines ESB auf die Genauigkeit von ermittelten Werten ist in Fig. 7a bis 7d dargestellt, welche beispielhafte Diagrammdarstellungen von Messwerten und modellierten Werten einer Generatorimpedanz in Abhängigkeit einer Frequenz bei verschiedenen Betriebszuständen illustrieren.

Gezeigt ist der Verlauf des Betrags der Impedanz |Z|, der Phase ϕ, der Realteil Re{Z} der Generatorimpedanz Z_{PV} und der Imaginärteil Im{Z} der Generatorimpedanz Z_{PV} über einer Frequenz f jeweils ohne Einstrahlung (linke Seite der Figuren - Symbol Mond) und mit Einstrahlung (rechte Seite der Figuren - Symbol Sonne). Gezeigt ist auch der Vergleich von Verläufen, die jeweils aus gemessenen Werten (kreisförmige Messpunkte) stammenzweier Modelle, die im Folgenden beschrieben werden, bestimmt wurden.

Der Darstellung gemäß Fig. 7 liegt ein PV-Modul oder einen PV-Generator zugrunde, bestehend aus gleichartigen Zellen im jeweils gleichen Betriebszustand, dar. Der Zuleitungswiderstand 20 (siehe Fig. 4) ist in diesem Beispiel ausreichend hoch, um vernachlässigt werden zu können, zum Beispiel weil die Leitungslänge hinreichend klein ist. Bei Nacht ist ebenfalls der Generatorwiderstand R_{D} 24 vergleichsweise hoch. Soll lediglich der Verlauf des Betrags der Impedanz |Z|, der Phase ϕ, oder der Imaginärteil Im{Z} der Generatorimpedanz Z_{PV} bei Nacht modelliert werden, so kann der Generatorwiderstand R_{D} 24 gegebenenfalls vernachlässigt werden. Es ergibt sich in diesem Fall vereinfacht ein sogenannter RLC Ansatz, d.h. das Wechselstromverhalten wird mittels eines ESB nachgebildet, welches aus einer Reihenschaltung eines Widerstandes, einer Induktivität, und einer Kapazität besteht. Es ergibt sich aus dem RLC-Modell ein Verlauf der Generatorimpedanz Z_{PV}, der mit den gestrichelten Linien dargestellt ist.

Da der Widerstandswert von R_{D} aus der vorliegenden Erfahrung heraus bei Tag drastisch sinkt wird, ist das reale Verhalten bei Tag mit einem einfachen RLC-Ansatz in diesem Fall nicht mehr nachbildbar, eine Überwachung des Generators mittels Kenngrößen des zugrundeliegenden ESB wird unmöglich. Bei Berücksichtigung des Generatorwiderstands R_{D} 24 im Rahmen eines erweiterten Modells (in Fig. 7 gekennzeichnet durch die durchgehenden Linien) entsprechend des ESB aus Fig. 3 bzw. Fig. 4 hingegen lässt sich das Wechselstromverhalten sowohl am Tag (bei Bestrahlung und in unterschiedlichen Betriebszuständen) als auch bei Nacht hinreichend genau beschreiben. Auf diese Weise kann der Generator auch bei Tage unabhängig vom Betriebszustand zuverlässig überwacht werden. Es ist zum Beispiel so möglich, den Serienwiderstand R_{S} 22 auch bei Tage laufend zu bestimmen, und bei Überschreiten eines vorbestimmten Grenzwertes ein Alarmsignal auszulösen.

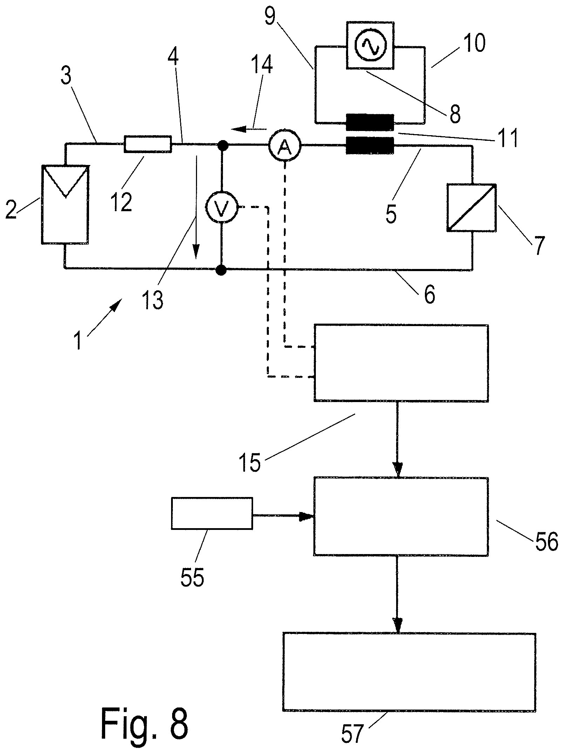

Zur Identifikation der Modellparameter, die zur oben beschriebenen Modellierung und Berechnung dienen, muss zunächst die komplexwertige Generatorimpedanz Z_{PV} gemessen werden. Eine dazu geeignete Schaltungsanordnung kann der DE 10 2006 052 295 B3 entnommen werden. Zur Parameteridentifikation der oben beschriebenen Ersatzschaltbilder zeigt Fig. 8 dazu ein beispielhaftes Blockschaltbild einer elektrischen Anlage mit einer Photovoltaikanlage 1 mit einem Ausführungsbeispiel einer erfindungsgemäßen Vorrichtung zur Überwachung von Kontakten der Photovoltaikanlage 1.

Fig. 8 entspricht zum großen Teil der Fig. 1, wobei jedoch ein Ausgang der Mess- und Auswertungseinrichtung 15 mit einer Bearbeitungseinrichtung 56 verbunden ist. Die Mess- und Auswertungseinrichtung 15 dient zur Bestimmung der Generatorimpedanz Z_{PV}. Die Bearbeitungseinrichtung 56 ermittelt die einzelnen Parameter und kann mit einer Basis für Expertenwissen 55, z. B. einer Datenverarbeitungsanlage, verknüpft sein. Nach einer Identifikation der Parameter werden diese einer Weiterverarbeitungs- und Speichereinrichtung 57 übergeben. Hier werden sie gespeichert und/oder in einem Diagnosealgorithmus zur Überwachung der Kontakte der Photovoltaikanlage 1 ausgewertet. Entsprechende Ausgaben, z.B. Alarmsignale und/oder -mitteilungen an übergeordnete Überwachungszentralen, können anschließend erfolgen. Ebenso kann eine Zellengruppe, bei welcher Fehler ermittelt wurden, abgetrennt bzw. abgeschaltet werden, um weitere Fehler bzw. daraus resultierende mögliche Schäden zu verhindern.

Zur Berechnung der Modellparameter ist neben dem Betrag der Generatorimpedanz Z_{PV} auch die Phaseninformation notwendig. Alternativ kann aber auch der Realteil Re{Z} und/oder der Imaginärteil Im{Z} der Generatorimpedanz Z_{PV} (diese beinhalten ebenfalls die Phaseninformation) oder beliebige Kombinationen gemessen werden. Die Bestimmung des Serienwiderstandes Rₛ zur Erkennung von Kontaktalterung mit dem Modellansatz des beispielhaften zweiten Ersatzschaltbilds gemäß Fig. 4 lässt sich beispielsweise allein aus dem Realteil Re{Z} der Generatorimpedanz Z_{PV} über drei Messwerte des Frequenzgangs berechnen. Mit Hilfe eines individuell aufgestellten und gegebenenfalls gewichteten Gütekriteriums und mit Hilfe von nichtlinearen Suchverfahren lassen sich alle gesuchten Parameter der vorgestellten Ersatzschaltbilder berechnen.

Die Erfindung ist nicht auf die beschriebenen Ausführungsbeispiele beschränkt, die auf vielfache Weise abgewandelt werden können. Insbesondere ist es möglich, die genannten Merkmale in anderen als den genannten Kombinationen auszuführen.

Eine Bestimmung relevanter Kennwerte eines ESB kann selbstverständlich nicht nur wie geschildert entsprechend dem bekannten Verfahren erfolgen, sondern auch nach weiteren Verfahren.

So können z.B. die mittels der Mess- und Auswertungseinrichtung 15 ermittelten bzw. berechneten Werte des Betrags der Generatorimpedanz Z_{PV} und ϕ bzw. Re{Z} und Im {Z} sowie den entsprechenden Frequenzwerten unter Verwendung von Expertenwissen 55 mittels der zur Verarbeitung von Expertenwissen 55 ausgestalteten Bearbeitungseinrichtung 56 unter Berücksichtigung eines ESB weiterverarbeitet und zur Bestimmung von Kennwerten verwendet werden.

Durch geschicktes Formulieren von Expertenwissen 55 in Nebenbedingungen können, falls notwendig, Mehrdeutigkeiten vermieden und der Parameterraum eingeschränkt werden.

In Hinsicht auf die vorstehende Beschreibung bevorzugter Ausführungsbeispiele sei angemerkt, dass nachfolgend einige bevorzugte Ausgestaltungen auch im Detail beschrieben werden, dass die Erfindung aber nicht auf diese Ausgestaltungen beschränkt ist, sondern im Rahmen der Ansprüche beliebig variiert ausgestaltet werden kann. Insbesondere sind Begriffe wie "oben", "unten", "vorne" oder "hinten" nicht einschränkend zu verstehen sondern beziehen sich lediglich auf die jeweils dargestellte Anordnung. Zudem sind, wenn einzelne Bestandteile erläutert werden, diese - wenn nicht anders erwähnt - grundsätzlich auch in mehrfacher Ausgestaltung denkbar. Unter den Schutzbereich fallen zudem auch fachmännische Abwandlungen der dargestellten Anordnungen und Verfahren sowie äquivalente Ausgestaltungen.

### Bezugszeichen

- 1: Photovoltaikanlage
- 2: Photovoltaikmodul
- 3...6: Elektrische Leitung
- 7: Wechselrichter
- 8: Funktionsgenerator
- 9...10: Elektrische Leitung
- 11: Einkopplung seinrichtung
- 12: Zuleitungsimpedanz Z_{L}
- 13: Messspannung
- 14: Messstrom
- 15: Mess- und Auswertungseinrichtung
- 16...18: Generatorimpedanz Z_{PV}
- 20: Zuleitungswiderstand R_{L}
- 21: Zuleitungsinduktivität L
- 22: Serienwiderstand R_{S}
- 23, 23a, 23b: Generatorkapazität C
- 24, 24a, 24b: Generatorwiderstand R_{D}
- 30: Photovoltaikgenerator
- 30a...e: Zelle
- 32: Erste Zellengruppe
- 33: Erstes Teilersatzschaltbild
- 34: Zweite Zellengruppe
- 35: Zweites Teilersatzschaltbild
- 36: Zusammengefasstes Ersatzschaltbild
- 40: Ersatzschaltbild PV-Generator
- 41: Teilersatzschaltbild Zuleitung
- 42: Zuleitungsinduktivität L_{L}
- 43: Zuleitungswiderstand R_{L}
- 44: Zuleitungskapazität C_{L}
- 55: Expertenwissen
- 56: Bearbeitungseinrichtung
- 57: Weiterverarbeitungs- und Speichereinrichtung

## Patentansprüche

1. Verfahren zur Diagnose, insbesondere Überwachung, von Kontakten einer Photovoltaikanlage (1), mit folgenden Verfahrensschritten:
- Einkoppeln eines mehrere Frequenzen umfassenden Testsignals in die Photovoltaikanlage (1),
- Auskoppeln eines Antwortsignals aus der Photovoltaikanlage (1) und Ermitteln einer Generatorimpedanz (Z_{PV}) der Photovoltaikanlage (1) mittels einer Auswertung des Antwortsignals; und
- Überwachen von Kontakten der Photovoltaikanlage (1) unabhängig von Betriebszuständen der Photovoltaikanlage (1) durch Modellieren eines Wechselstromverhaltens der Photovoltaikanlage (1) anhand eines Betrags und einer Phaseninformation der ermittelten Generatorimpedanz (Z_{PV}), **dadurch gekennzeichnet, dass** das Wechselstromverhalten der Photovoltaikanlage (1) anhand eines Ersatzschaltbildes modelliert wird, wobei die Überwachung durch eine Kenngröße des Ersatzschaltbildes erfolgt, welche einen Wert aufweist, der im wesentlichen unabhängig von Betriebszuständen der Photovoltaikanlage (1) ist.

2. Verfahren nach Anspruch 1, **dadurch gekennzeichnet, dass** das Ersatzschaltbild eine Reihenschaltung einer Zuleitungsinduktivität (21), eines Serienwiderstandes (22), und einer Generatorkapazität (23) mit parallelem Generatorwiderstand (24) aufweist.

3. Verfahren nach Anspruch 2, **dadurch gekennzeichnet, dass** die Überwachung der Photovoltaikanlage (1) mittels eines Wertes des Serienwiderstandes (22) erfolgt.

4. Verfahren nach einem der Ansprüche 1 bis 3, **dadurch gekennzeichnet, dass** das Ersatzschaltbild weiterhin ein Teilersatzschaltbild zur Modellierung einer langen Zuleitung umfasst, welches eine Reihenschaltung aus einer Zuleitungsinduktivität (42) und einem Zuleitungswiderstand (43), sowie einer zur Generatorkapazität (23) parallelen Zuleitungskapazität (44) aufweist.

5. Verfahren nach einem der Ansprüche 2 bis 4, **dadurch gekennzeichnet, dass** das Ersatzschaltbild eine Anzahl von in Reihe geschalteten Paaren von parallelen Generatorkapazitäten (23a, 23b) und Generatorwiderständen (24a, 24b) aufweist.

6. Verfahren nach Anspruch 5, wobei jedes Paar von parallelen Generatorkapazitäten (23a, 23b) und Generatorwiderständen (24a, 24b) einen Teil der Photovoltaikanlage (1) nachbildet, der sich in einem einheitlichen Betriebszustand befindet.

7. Verfahren nach Anspruch 5, wobei jedes Paar von parallelen Generatorkapazitäten (23a, 23b) und Generatorwiderständen (24a, 24b) einen Teil der Photovoltaikanlage (1) nachbildet, der eine einheitliche Bauart aufweist.

8. Verfahren nach einem der Ansprüche 2 bis 7, **dadurch gekennzeichnet, dass** in dem Ersatzschaltbild der Zuleitungsinduktivität (21) ein Zuleitungswiderstand (20) parallel geschaltet ist.

9. Verfahren nach einem der Ansprüche 1 bis 8, **dadurch gekennzeichnet, dass** zumindest ein Teilersatzschaltbild eine Komponente umfasst, welche eine Temperatur berücksichtigt.

10. Verfahren nach einem der vorhergehenden Ansprüche, **dadurch gekennzeichnet, dass** das Überwachen von Kontakten der Photovoltaikanlage (1) mit Hilfe von Expertenwissen (55) durchgeführt wird.

11. Vorrichtung zur Überwachung von Kontakten einer Photovoltaikanlage (1), aufweisend:
- einen Funktionsgenerator (8) zur Erzeugung eines Testsignals mit einer festlegbaren Anzahl von Schwingungsanregungen mit unterschiedlichen Frequenzen, und mit einer Einkopplungseinrichtung (11) zur Einkopplung des Testsignals in die Photovoltaikanlage (1);
- eine Mess- und Auswertungseinrichtung (15) zur Messung und Auswertung einer Messspannung (13) und eines Messstroms (14) zur Ermittlung einer Generatorimpedanz (Z_{PV}), der Photovoltaikanlage (1);
- eine Bearbeitungseinrichtung (56) zur Identifikation von Parametern; und eine Weiterverarbeitungs- und Speichereinrichtung (57) zur Überwachung von Kontakten der Photovoltaikanlage (1) durch Modellierung eines Wechselstromverhaltens der Photovoltaikanlage (1) und Vergleichen mit vorher festgelegten Referenzwerten,
**dadurch gekennzeichnet,**
**dass** das Wechselstromverhalten der Photovoltaikanlage (1) anhand eines Ersatzschaltbildes modelliert wird, wobei die Überwachung durch eine Kenngröße des Ersatzschaltbildes erfolgt, welche einen Wert aufweist, der im wesentlichen unabhängig von Betriebszuständen der Photovoltaikanlage (1) ist.

12. Vorrichtung nach Anspruch 11, **dadurch gekennzeichnet, dass** die Bearbeitungseinrichtung (56) zur Verarbeitung von Parametern mit Expertenwissen (55) ausgestaltet ist.

13. Vorrichtung nach Anspruch 11 oder 12, **dadurch gekennzeichnet, dass** die Weiterverarbeitungs- und Speichereinrichtung (57) eine Auswerteeinrichtung zur Charakterisierung mindestens einer Eigenschaft, die repräsentativ ist für eine Alterung von Komponenten der Photovoltaikanlage (1) aufweist.

14. Vorrichtung nach einem der Ansprüche 11 bis 13, **dadurch gekennzeichnet, dass** die Vorrichtung in einen Wechselrichter (7) der Photovoltaikanlage (1) integriert ist.

## Claims

1. A method for the diagnosis, in particular monitoring, of contacts of a photovoltaic system (1), with the following steps:
- coupling a test signal comprising several frequencies into the photovoltaic system (1),
- coupling out a response signal from the photovoltaic system (1) and determining a generator impedance (ZPV) of the photovoltaic system (1) by evaluating the response signal; and
- monitoring contacts of the photovoltaic system (1) independently of operating states of the photovoltaic system (1) by modelling an alternating current behaviour of the photovoltaic system (1) using an amount and phase information of the determined generator impedance (ZPV),
**characterized in that**
the alternating current behaviour of the photovoltaic system (1) is modelled on the basis of an equivalent circuit diagram, the monitoring being effected by a characteristic of the equivalent circuit diagram which has a value which is substantially independent of operating states of the photovoltaic system (1).

2. The method according to claim 1, **characterized in that** the equivalent circuit diagram comprises a series connection of a supply line inductance (21), a series resistance (22), and a generator capacitance (23) with parallel generator resistance (24).

3. The method according to claim 2, **characterized in that** the photovoltaic system (1) is monitored by means of a value of the series resistance (22).

4. The method according to one of claims 1 to 3, **characterized in that** the equivalent circuit diagram further comprises a partial equivalent circuit diagram for modelling a long supply line, which has a series circuit comprising a supply line inductance (42) and a supply line resistance (43), and a supply line capacitance (44) parallel to the generator capacitance (23).

5. The method according to one of claims 2 to 4, **characterized in that** the equivalent circuit diagram comprises a number of pairs of parallel generator capacitances (23a, 23b) and generator resistors (24a, 24b) connected in series.

6. The method according to claim 5, wherein each pair of parallel generator capacitances (23a, 23b) and generator resistors (24a, 24b) replicates a portion of the photovoltaic system (1) which is in a uniform operating state.

7. The method according to claim 5, wherein each pair of parallel generator capacitances (23a, 23b) and generator resistors (24a, 24b) replicates a part of the photovoltaic system (1) having a uniform design.

8. The method according to one of claims 2 to 7, **characterized in that** in the equivalent circuit diagram the supply line resistor (20) is connected in parallel to the supply line inductance (21).

9. The method according to one of claims 1 to 8, **characterized in that** at least one partial equivalent circuit diagram comprises a component which takes a temperature into account.

10. The method according to one of the preceding claims, **characterized in that** the monitoring of contacts of the photovoltaic system (1) is carried out with the aid of expert knowledge (55).

11. A device for monitoring contacts of a photovoltaic system (1), comprising:
- a function generator (8) for generating a test signal having a definable number of vibration excitations at different frequencies, and coupling in means (11) for coupling the test signal into the photovoltaic system (1);
- a measuring and evaluation device (15) for measuring and evaluating a measuring voltage (13) and a measuring current (14) for determining a generator impedance (ZPV) of the photovoltaic system (1);
- a processing unit (56) for identifying parameters; and
- a further processing and storage unit (57) for monitoring contacts of the photovoltaic system (1) by modelling an alternating current behaviour of the photovoltaic system (1) and comparing it with previously determined reference values,
**characterized in that**
the alternating current behaviour of the photovoltaic system (1) is modelled on the basis of an equivalent circuit diagram, the monitoring being effected by a characteristic of the equivalent circuit diagram which has a value which is substantially independent of operating states of the photovoltaic system (1).

12. The device according to claim 11, **characterized in that** the processing device (56) is designed for processing parameters with expert knowledge (55).

13. The device according to claim 11 or 12, **characterized in that** the further processing and storage device (57) has an evaluation device for characterizing at least one property which is representative of an aging of components of the photovoltaic system (1).

14. The device according to one of claims 11 to 13, **characterized in that** the device is integrated in an inverter (7) of the photovoltaic system (1).

## Revendications

1. Procédé, destiné à diagnostiquer, notamment à superviser des contacts d'une installation photovoltaïque (1), comprenant les étapes de procédé suivantes :
- de l'injection dans l'installation photovoltaïque (1) d'un signal de test comprenant plusieurs fréquences,
- de l'extraction d'un signal de réponse de l'installation photovoltaïque (1) et de la détermination d'une impédance de générateur (Z_{PV}) de l'installation photovoltaïque (1) au moyen d'une évaluation du signal de réponse ; et
- de la supervision de contacts de l'installation photovoltaïque (1) indépendamment d'états de service de l'installation photovoltaïque (1) par modélisation d'un comportement en courant alternatif de l'installation photovoltaïque (1) à l'aide d'un montant et d'une information de phase de l'impédance de générateur (Z_{PV}) déterminée,
**caractérisé en ce que** le comportement en courant alternatif de l'installation photovoltaïque (1) est modélisé à l'aide d'un circuit équivalent, la supervision s'effectuant par une grandeur caractéristique du circuit équivalent, laquelle présente une valeur qui est sensiblement indépendante d'états de service de l'installation photovoltaïque (1).

2. Procédé selon la revendication 1, **caractérisé en ce que** le circuit équivalent comporte une connexion en série d'une inductance de ligne d'alimentation (21), d'une résistance en série (22) et d'une capacité de générateur (23) à résistance de générateur parallèle (24).

3. Procédé selon la revendication 2, **caractérisé en ce que** la supervision de l'installation photovoltaïque (1) s'effectue au moyen d'une valeur de la résistance en série (22).

4. Procédé selon l'une quelconque des revendications 1 à 3, **caractérisé en ce que** le circuit équivalent comprend par ailleurs un circuit équivalent partiel pour la modélisation d'une longue ligne d'alimentation, lequel comporte une connexion en série d'une inductance de ligne d'alimentation (42) et d'une résistance de ligne d'alimentation (43), ainsi qu'une capacité de ligne d'alimentation (44) parallèle à la capacité de générateur (23).

5. Procédé selon l'une quelconque des revendications 2 à 4, **caractérisé en ce que** le circuit équivalent comporte un nombre de paires connectées en série de capacités de générateur (23a, 23b) et de résistances de générateur (24a, 24b) parallèles.

6. Procédé selon la revendication 5, chaque paire de capacités de générateur (23a, 23b) et de résistances de générateur (24a, 24b) parallèles reproduisant une partie de l'installation photovoltaïque (1) qui se trouve dans un état de service homogène.

7. Procédé selon la revendication 5, chaque paire de capacités de générateur (23a, 23b) et de résistances de générateur (24a, 24b) parallèles reproduisant une partie de l'installation photovoltaïque (1) qui présente un type de construction homogène.

8. Procédé selon l'une quelconque des revendications 2 à 7, **caractérisé en ce que** dans le circuit équivalent de l'inductance de ligne d'alimentation (21), une résistance de ligne d'alimentation (20) est connectée en parallèle.

9. Procédé selon l'une quelconque des revendications 1 à 8, **caractérisé en ce qu'**au moins un circuit équivalent partiel comprend un composant qui tient compte d'une température.

10. Procédé selon l'une quelconque des revendications précédentes, **caractérisé en ce que** la supervision de contacts de l'installation photovoltaïque (1) est réalisée à l'aide de connaissances d'experts (55) .

11. Dispositif, destiné à superviser des contacts d'une installation photovoltaïque (1), comportant :
- un générateur de fonctions (8) destiné à générer un signal de test avec un nombre pouvant être fixé d'excitations vibratoires à différentes fréquences et avec un système d'injection (11), destiné à injecter le signal de test dans l'installation photovoltaïque (1) ;
- un système de mesure et d'évaluation (15), destiné à mesurer et à évaluer une tension de mesure (13) et un courant de mesure (14) pour déterminer une impédance de générateur (Z_{PV}) de l'installation photovoltaïque (1) ;
- un système de traitement (56), destiné à identifier des paramètres ; et un système de traitement ultérieur et de mémorisation (57), destiné à superviser des contacts de l'installation photovoltaïque (1) par modélisation d'un comportement en courant alternatif de l'installation photovoltaïque (1) et par comparaison avec des valeurs de référence précédemment fixées,
**caractérisé en ce que**
le comportement en courant alternatif de l'installation photovoltaïque (1) est modélisé à l'aide d'un circuit équivalent, la supervision s'effectuant par une grandeur caractéristique du circuit équivalent, laquelle présente une valeur qui est sensiblement indépendante d'états de service de l'installation photovoltaïque (1).

12. Dispositif selon la revendication 11, **caractérisé en ce que** le système de traitement (56) est conçu pour traiter des paramètres avec des connaissances d'expert (55).

13. Dispositif selon la revendication 11 ou 12, **caractérisé en ce que** le système de traitement ultérieur et de mémorisation (57) comporte un système d'évaluation, destiné à caractériser au moins une propriété qui est représentative pour un vieillissement de composants de l'installation photovoltaïque (1).

14. Dispositif selon l'une quelconque des revendications 11 à 13, **caractérisé en ce que** le dispositif est intégré dans un onduleur (7) de l'installation photovoltaïque (1).
